# EUROPEAN PATENT APPLICATION

(11) **EP 2 770 547 A2**
(43) Date of publication of application: **27.08.2014**
(21) Application number: 13185027.3
(22) Date of filing: 18.09.2013
(51) Int. Cl.: H01L 33/50

(54) **Light emitting module and lighting device**

(30) Priority: 21.02.2013 JP 2013032645
(71) Applicant: Toshiba Lighting & Technology Corporation, Yokosuka-shi, Kanagawa 237-8510 (JP)
(72) Inventor: Watanabe, Miho, Kanagawa, 237-8510 (JP); Oyaizu, Tsuyoshi, Kanagawa, 237-8510 (JP)
(74) Representative: Bokinge, Ole

(57) **Abstract**

A light emitting module according to one embodiment includes a substrate (3); a light emitting body (5) disposed on the substrate (3); a first phosphor (15) which is excited by emitted light of the light emitting body (5); and a second phosphor (17) which is arranged between the first phosphor (15) and the light emitting body (5). The first phosphor (15) has a light emitting peak whose half-value width is 20 nm or less in a wavelength range from 610 nm to less than 650 nm. The second phosphor (17) is excited by the emitted light of the light emitting body (5), and has the light emitting peak in the wavelength range between a peak wavelength of a light emitting spectrum of the light emitting body (5) and the peak wavelength of the light emitting spectrum of the first phosphor (15).

## Description

### FIELD

Embodiments described herein relate generally to a light emitting module and a lighting device.

### BACKGROUND

Most light emitting modules used as a light source of lighting equipment include a blue light emitting element and a phosphor which is excited by emitted light from the blue light emitting element, and output white light obtained by combining blue light emitted from the blue light emitting element and longer wavelength light emitted from the phosphor. Then, for the phosphor converting the blue light into the long wavelength light, it is desirable to use a phosphor which has a high luminous efficiency and exhibits less decrease of luminous flux as increasing ambient temperature. For example, in view of such characteristics, a YAG phosphor emitting yellow light and a CASN phosphor emitting red light are used.

### BRIEF DESCRIPTION OF THE DRAWINGS

FIGS. 1A and 1B are schematic cross-sectional views illustrating a light emitting module and a lighting device according to an embodiment;
FIGS. 2A and 2B are graphs illustrating characteristics of a phosphor according to the embodiment;
FIG. 3 is a graph illustrating temperature characteristics of a phosphor according to the embodiment; and
FIG. 4 is a schematic cross-sectional view illustrating a light emitting module according to a modification example of the embodiment.

### DETAILED DESCRIPTION

A light emitting module according to one embodiment includes a substrate; a light emitting body disposed on the substrate; and a phosphor layer having a first phosphor which is excited by emitted light of the light emitting body, and a second phosphor which is arranged between the light emitting body and the first phosphor. The first phosphor has a light emitting peak whose half-value width is 20 nm or less in a wavelength range from 610 nm to less than 650 nm. The second phosphor is excited by the emitted light of the light emitting body, and has the light emitting peak in the wavelength range between a peak wavelength of a light emitting spectrum of the light emitting body and the peak wavelength of the light emitting spectrum of the first phosphor.

The light emitting spectrum of a CASN or SCASN phosphor used as a red phosphor includes a wavelength band of low relative visibility exceeding 650 nm, and a long wavelength end of an excitation band exceeds 600 nm. That is, there is an aspect of absorbing light in a wavelength region of high relative visibility and emitting the light of the low relative visibility. Therefore, in the light emitting module containing many red phosphors and having a low correlated color temperature, average color rendering index and luminous efficiency are reduced. Accordingly, one embodiment provides a light emitting module and a lighting device which can improve color rendering properties and the luminous efficiency.

Hereinafter, the embodiment will be described with reference to the drawings. The same reference numerals are given to the same elements in the drawing, and detailed description thereof will be appropriately omitted, and different elements will be described. The drawings are schematically and conceptually prepared, and thus, a relationship between a thickness and a width of each element and a ratio of sizes between the elements are not necessarily limited to real things. In addition, even if the same element is represented, in some cases, the element may be represented by mutually different dimensions or ratios depending on the drawing.

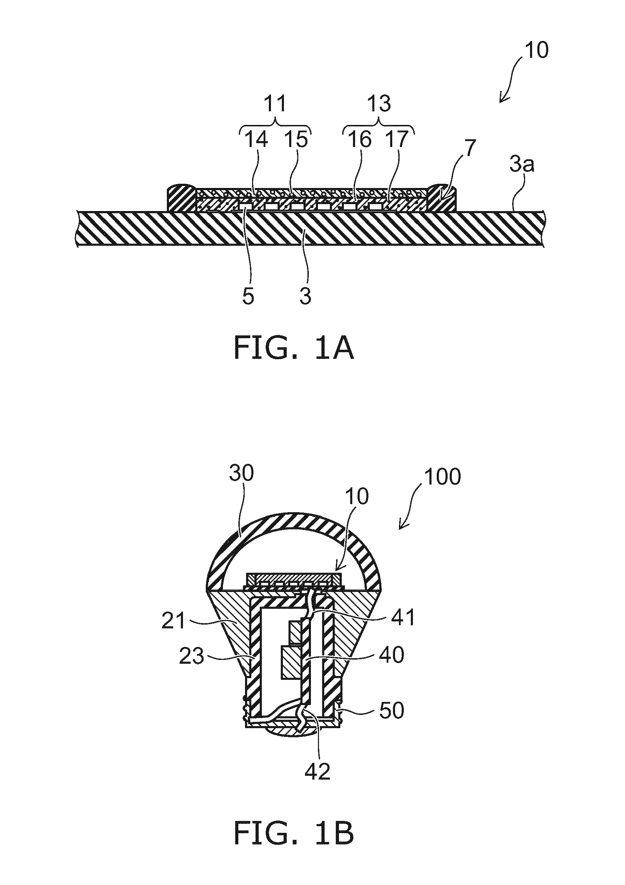

FIGS. 1A and 1B are schematic cross-sectional views illustrating a light emitting module 10 and a lighting device 100 according to the embodiment. FIG. 1A illustrates the light emitting module 10 and FIG. 1B illustrates the lighting device 100 in which the light emitting module is embedded.

As illustrated in FIG. 1A, the light emitting module 10 includes a substrate 3, a light emitting body 5 disposed on the substrate 3, and phosphor layers 11 and 13. The phosphor layer 11 includes a first phosphor which is excited by emitted light of the light emitting body 5. The phosphor layer 13 includes a second phosphor which is excited by the emitted light of the light emitting body 5, and is disposed between the light emitting body 5 and the phosphor layer 11.

That is, on the substrate 3, the second phosphor is arranged between the first phosphor and the light emitting body 5. In the following example, a structure where the phosphor layer 11 including the first phosphor and the phosphor layer 13 including the second phosphor are stacked will be described, but the embodiment is not limited thereto. For example, the first phosphor and the second phosphor may be included in one layer, and the second phosphor may be arranged between the first phosphor and the light emitting body 5.

The first phosphor is a red phosphor 15 emitting red light. The second phosphor has a light emitting peak in the wavelength band between the peak wavelength of the light emitting spectrum of the light emitting body 5 and the peak wavelength of the light emitting spectrum of the red phosphor 15. Hereinafter, an example will be described using a yellow phosphor 17 emitting yellow light as the second phosphor, but is not limited thereto. For example, as the second phosphor, a green phosphor may be used, and the yellow phosphor and the green phosphor may be mixed together for use.

For example, the substrate 3 is a ceramic substrate. The light emitting body 5 emits the light of 400 to 480 nanometers (nm) in the wavelength, and excites the red phosphor 15 and the yellow phosphor 17. Specifically, the light emitting body 5 is a Light Emitting Diode (LED) and for example, emits blue light of 450 to 460 nm in a dominant wavelength.

For example, the light emitting body 5 is mounted on an upper surface 3a of the substrate 3 via an adhesive. Multiple light emitting bodies 5 are mounted on the substrate 3, and are connected to each other in series or in parallel using a metal wire. Then, a bank 7 is disposed so as to surround the periphery of a region on which the light emitting bodies 5 are mounted. For example, the bank 7 includes a white resin.

For example, a translucent resin 16 in which the yellow phosphor 17 is dispersed is poured and cured inside the bank 7. In this manner, the phosphor layer 13 covering the light emitting body 5 is disposed. Subsequently, a translucent resin 14 in which the red phosphor 15 is dispersed is poured and cured. In this manner, the phosphor layer 11 is disposed on the phosphor layer 13. For example, the red phosphor 15 includes a phosphor represented by a chemical formula of K₂SiF₆:Mn, and for example, the yellow phosphor 17 is a YAG phosphor.

For example, the light emitting module 10 is embedded in the lighting device 100 as a light source. As illustrated in FIG. 1B, for example, the lighting device 100 is an electric bulb type lamp, and includes the light emitting module 10, a housing 21 on which the light emitting module 10 is mounted, and a cover 30 covering the light emitting module 10. The lighting device 100 illustrated herein is one example, and thus, the embodiment is not limited thereto.

A power conversion unit 40 supplying power to the light emitting module 10 is disposed inside the housing 21. The power conversion unit 40 is electrically connected to the light emitting module 10 and a socket 50 via lead wires 41 and 42. In addition, the power conversion unit 40 is accommodated in an insulating case 23 disposed inside the housing 21. The power conversion unit 40 receives AC power supply from a commercial power supply (not illustrated) via the socket 50, and for example, supplies the power to the light emitting module 10 by converting the AC power into DC power.

The light emitting module 10 emits white light by receiving the power supply from the power conversion unit 40. That is, the white light is emitted by mixing the blue light emitted from the light emitting body 5, the red light emitted from the red phosphor 15 and the yellow light emitted from the yellow phosphor 17.

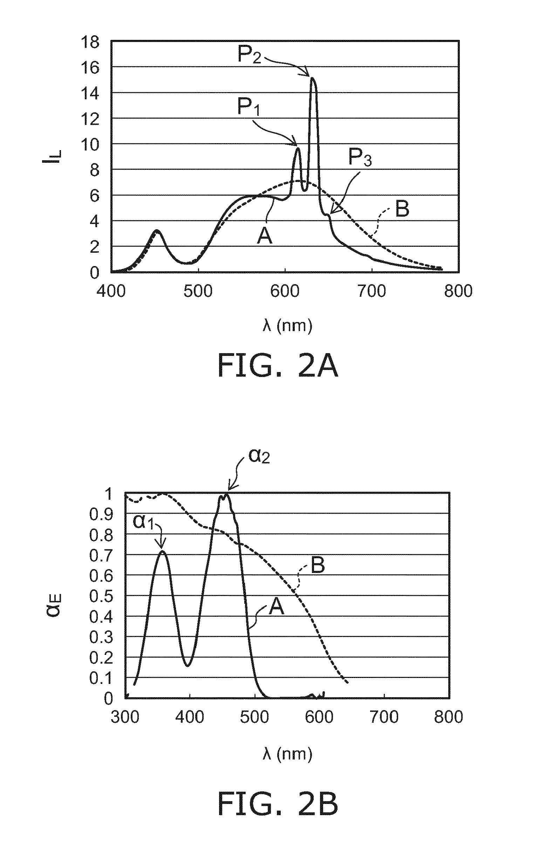

Next, referring to FIGS. 2A to 3, characteristics of the light emitting module 10 will be described. FIGS. 2A to 3 are graphs illustrating the characteristics of the red phosphor 15 included in the phosphor layer 11.

FIG. 2A is a graph illustrating a light emitting spectrum of a phosphor. A horizontal axis represents a light emitting wavelength λ, and a vertical axis represents a light emitting intensity I_{L}. A graph A in FIG. 2A illustrates the light emitting spectrum of the red phosphor 15, and a graph B illustrates the light emitting spectrum of a CASN phosphor according to a comparative example.

As illustrated in the graph A, the red phosphor 15 has light emitting peaks P₁, P₂ and P₃ whose half-value width is 20 nm or less in the wavelength range from 610 nm to less than 650 nm. In addition, the light emitting intensity I_{L} in the wavelength region of 650 nm or more is equal to or less than half of the light emitting peaks P₁ and P₂. In contrast, as illustrated in graph B, the CASN phosphor has the light emitting peaks in the wavelength range from 610 to 620 nm, and the half-value width reaches approximately 170 nm. Then, the light emitting intensity in the wavelength of 650 nm is approximately 80% of the light emitting intensity in the peak wavelength.

In the red phosphor 15 according to the present embodiment, the intensity of the light emitting spectrum in the wavelength band of 650 nm or more where relative visibility is reduced is lower than that of the CASN phosphor. Therefore, if the correlated color temperature and the average color rendering index are the same as each other, luminous flux of the light emitting module using the red phosphor 15 is larger than that of one using the CASN phosphor. That is, the luminous efficiency is high.

FIG. 2B is a graph illustrating an excitation spectrum of a phosphor. The horizontal axis represents an excited-light wavelength λ, and the vertical axis represents a relative light emitting intensity α_{E}. The graph A in FIG. 2B illustrates the excitation spectrum of the red phosphor 15, and the graph B illustrates the excitation spectrum of a CASN phosphor according to a comparative example.

As illustrated in the graph A, the red phosphor 15 has an excitation band in the wavelength range from 300 nm to 550 nm, and has absorption peaks α₁ and α₂ of excited light in the vicinity of the wavelength of 350 nm and 450 nm. In contrast, as illustrated in the graph B, for example, the CASN phosphor has a spectrum gradually decreasing from the wavelength of 300 nm toward a longer wavelength side, and has the excitation band in the wavelength range exceeding 600 nm from a wavelength side shorter than 300 nm.

Here, the excitation band represents a wavelength range where the phosphor absorbs energy of the excited light and emits the light.

The absorption peak α₂ of the red phosphor 15 is overlapped with the peak wavelength of the light emitting spectrum of a blue LED. Then, the excitation band of the red phosphor 15 in the wavelength range of 500 nm or more is equal to or less than 10% of the absorption peak α₂. That is, in the red phosphor 15, a long wavelength end of the excitation band is located in the vicinity of 500 nm. Accordingly, the red phosphor 15 efficiently absorbs the emitted light of the blue LED, but scarcely absorbs the emitted light of the yellow phosphor 17.

In contrast, the excitation band of the CASN phosphor is spread toward the longer wavelength side up to the wavelength exceeding 600 nm. Then, the CASN phosphor absorbs the emitted light of the yellow phosphor 17 and converts the light into the red light. That is, in the light emitting module using the CASN phosphor, output light thereof includes components to be absorbed by both of the yellow phosphor 17 and the CASN phosphor. For this reason, the luminous efficiency of the light emitting module is reduced.

Thus, it is desirable that the long wavelength end of the excitation band of the first phosphor be a wavelength which is shorter than the wavelength of the light emitting peak of the second phosphor. The excitation band of K₂SiF₆: Mn included in the red phosphor 15 according to the embodiment is located at the wavelength side shorter than 520 nm, and the emitted light of the yellow phosphor 17 and the green phosphor is scarcely absorbed. Therefore, it is possible to increase the luminous efficiency of the light emitting module 10 by using K₂SiF₆:Mn.

For example, if compared by using the light emitting module of the average color rendering index of Ra 80 and the correlated color temperature of 2800 Kelvin (K), the luminous efficiency when using the CASN phosphor is 83 lumens (1m)/watt (W). In contrast, the luminous efficiency when using the red phosphor 15 including K₂SiF₆:Mn is 100 Im/W. In addition, when the same luminous efficiency is set, whereas the average color rendering index of the light emitting module using the CASN phosphor is 80, the average color rendering index of the light emitting module using the red phosphor 15 is 90. That is, in the light emitting module using the red phosphor 15 including K₂SiF₆:Mn, it is possible to increase at least any one of the luminous efficiency and the average color rendering index Ra.

Further, the phosphor has a larger absorption rate of the excited light, if the average particle diameter is increased. Therefore, it is possible to reduce the amount to be used and achieve cost reduction by increasing the average particle diameter of the red phosphor 15. For example, it is preferable to set the average particle diameter of the red phosphor 15 to 1.6 times or more than the average particle diameter of the yellow phosphor 17.

In the light emitting module including the blue LED as the light emitting body 5, when the correlated color temperature is set to 2,800 K, if the average particle diameter of the yellow phosphor 17 is set to 10 µm and the average particle diameter of the red phosphor 15 is set to 16 µm, the content (weight percent: wt%) of the red phosphor 15 is approximately 5 times the content of the yellow phosphor 17. Further, if the average particle diameter of the red phosphor 15 is set to 45 µm, the content thereof is reduced to 3.8 times the content of the yellow phosphor 17. Here, the content of the phosphor means the content in a layer including the phosphor thereof.

In addition, it is possible to reduce the amount of the yellow phosphor 17 to be used by using the red phosphor 15 according to the present embodiment. For example, the CASN phosphor absorbs the emitted light of the yellow phosphor 17, since the excitation spectrum is spread up to the wavelength of 650 nm. Therefore, in order to achieve a desired correlated color temperature, it is necessary to increase the yellow phosphor 17 by the amount to compensate for the absorption of the CASN phosphor.

On the other hand, in K₂SiF₆:Mn included in the red phosphor 15 according to the present embodiment, the long wavelength end of the excitation spectrum is 520 nm. Therefore, the emitted light of the yellow phosphor 17 need not be absorbed and thus it is not necessary to compensate for the absorption. Therefore, it is possible to reduce the content of the yellow phosphor 17. For example, in the light emitting module where the correlated color temperature is 3,000 K or less, the content (wt%) of the red phosphor 15 is equal to or more than 3 times the content (wt%) of the yellow phosphor 17. For example, in the light emitting module where the correlated color temperature is 2,800 K, when the average particle diameter of the red phosphor 15 is set to 20 to 30 µm, the content thereof is 6 to 7 times the content of the yellow phosphor 17 (YAG phosphor).

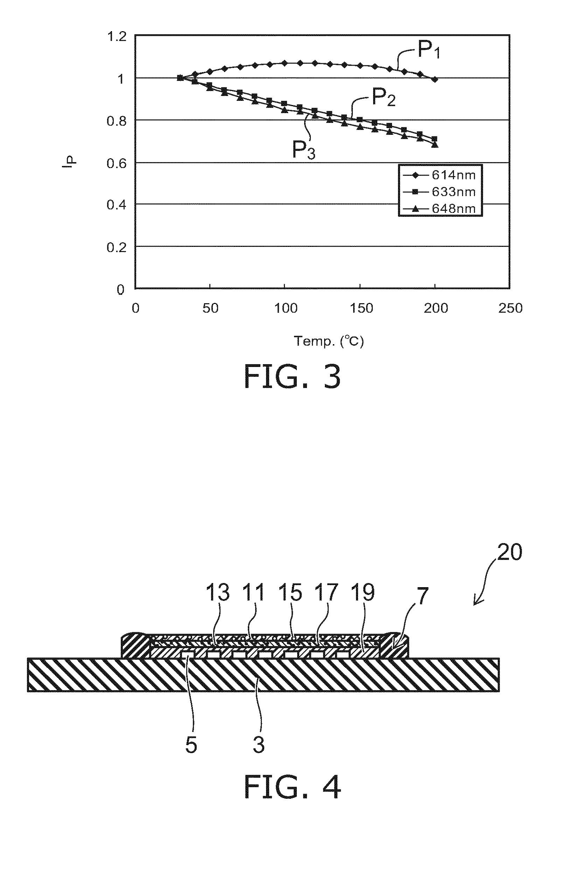

FIG. 3 is a graph illustrating temperature characteristics of the red phosphor 15 according to the embodiment. The horizontal axis represents a temperature of the light emitting module 10 and the vertical axis represents relative intensity I_{P} of the light emitting peak of the red phosphor 15.

The red phosphor 15 has multiple light emitting peaks P₁, P₂ and P₃ in the wavelength range from 610 nm to less than 650 nm (refer to FIG. 2A). These light emitting peaks respectively have the peak wavelength of 615 nm, 633 nm and 618 nm, corresponding to the light emitting peak of K₂SiF₆:Mn. Then, the half-value widths are respectively 20 nm or less.

FIG. 3 illustrates a temperature change of the light emitting intensity in each light emitting peak, based on the light emitting intensity of 25°C. As illustrated in FIG. 3, the light emitting intensity of the light emitting peak P₁ of the wavelength of 615 nm is not decreased in a temperature range from 25°C to 200°C, but is rather increased from 25°C to 100°C. On the other hand, the light emitting intensity of the light emitting peaks P₂ and P₃ in the peak wavelength of 633 nm and 648 nm is monotonically decreased along with the temperature rising, and is decreased to approximately 70% of 25°C at 200°C.

Human relative visibility reaches a peak in the wavelength of 555 nm, and is decreased as the wavelength is longer. Therefore, in the red phosphor 15, the light emitting intensity of the light emitting peak P₁ in the peak wavelength of 615 nm where the relative visibility is high is not decreased in contrast to the temperature rising of the module. On the other hand, in the light emitting peaks P₂ and P₃ where the temperature change of the light emitting intensity is considerable, the visibility is low. Therefore, when considering the relative visibility, the temperature change of the light emitting intensity of the red phosphor 15 is suppressed. Then, in the light emitting module 10 using the red phosphor 15, it is possible to suppress temperature quenching in an operation for a large quantity of light.

In addition, the red phosphor 15 has a large stroke loss, and the temperature thereof is likely to rise. Therefore, if decrease in the light emitting intensity due to the temperature rising in the wavelength region where the relative visibility is high can be suppressed, it is possible to improve the temperature characteristics of the light emitting module 10. For example, in the light emitting module 10 using the red phosphor 15, it is possible to suppress temperature quenching in an operation for a large quantity of light.

Further, as described in the present embodiment, if the red phosphor 15 is arranged to be separated from the light emitting body 5, it is possible to reduce the influence of the temperature rising of the light emitting body 5. That is, it is possible to prevent color rendering properties and luminous efficiency of the light emitting module from being decreased due to both actions of the temperature rising resulting from the stroke loss and the temperature rising of the light emitting body 5.

When the red phosphor 15 and the yellow phosphor 17 are respectively contained in the phosphor layer 11 and the phosphor layer 13, it is desirable to select the translucent resins 14 and 16 so that a refractive index of the phosphor layer 11 is lower than a refractive index of the phosphor layer 13. In this manner, it is possible to improve extraction efficiency of the light emitted from an upper surface of the phosphor layer 11.

FIG. 4 is a schematic cross-sectional view of a light emitting module 20 according to a modification example of the embodiment. As illustrated in FIG. 4, the light emitting module 20 includes the substrate 3, the light emitting body 5 disposed on the substrate 3, and the phosphor layers 11 and 13. Then, an intermediate layer 19 covering the light emitting body 5 is further provided on the substrate 3. The phosphor layers 11 and 13 are sequentially stacked on the intermediate layer 19. The intermediate layer 19 allows the emitted light of the light emitting body 5 to be transmitted. Here, the term "transmission" is not limited to the transmission of all the emitted light of the light emitting body 5, but includes a case of absorbing a portion thereof.

For example, the intermediate layer 19 is a translucent resin such as silicone, and includes translucent inorganic oxide or glass. In addition, the intermediate layer 19 contains, for example, 20 wt% or more of the translucent inorganic oxide or the glass.

For example, in the light emitting module 10 illustrated in FIG. 1A, the light emitting body 5 is directly covered with the phosphor layer 13. Accordingly, the light emitting of the yellow phosphor 17 in the phosphor layer 13 is influenced by the temperature rising of the light emitting body 5. In contrast, in the light emitting module 20, the intermediate layer 19 isolates the phosphor layer 13 from the light emitting body 5. In this manner, it is possible to suppress, for example, the decrease in the luminous efficiency of each phosphor or the rising of the correlated color temperature by reducing the influence of the temperature rising of the light emitting body 5.

As described above, the light emitting module according to the present embodiments adopts the red phosphor 15 which does not emit the light in the wavelength region of 650 nm or more where the relative visibility is low and further does not absorb the emitted light in a visible light region where the visibility is high. In this manner, color rendering properties are improved, thereby enabling the high luminous efficiency to be obtained in the module of the low correlated color temperature. In addition, it is possible to reduce the content of the red phosphor 15 and achieve the cost reduction of the light emitting module by increasing the particle diameter of the red phosphor 15. Further, on the substrate 3, it is possible to improve the color rendering properties of the light emitting module and the temperature characteristics of the luminous efficiency by arranging the yellow phosphor 17 between the red phosphor 15 and the light emitting body 5.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope of the invention.

## Claims

1. A light emitting module comprising:
a substrate (3);
a light emitting body (5) disposed on the substrate (3);
a first phosphor (15) which is excited by emitted light of the light emitting body (5) and has a light emitting peak whose half-value width is 20 nm or less in a wavelength range from 610 nm to less than 650 nm; and
a second phosphor (17) arranged between the first phosphor (15) and the light emitting body (5), excited by the emitted light of the light emitting body (5), and having the light emitting peak in the wavelength range between a peak wavelength of a light emitting spectrum of the light emitting body (5) and the peak wavelength of the light emitting spectrum of the first phosphor (15).

2. The module according to claim 1,
wherein a long wavelength end of an excitation band of the first phosphor (15) is located in a wavelength side which is shorter than the peak wavelength of the light emitting spectrum of the second phosphor (17).

3. The module according to claim 1 or 2,
wherein light emitting intensity in a wavelength region of 650 nm or more of the first phosphor (15) is equal to or less than half of intensity of the light emitting peak.

4. The module according to any one of claims 1 to 3,
wherein the first phosphor (15) has multiple light emitting peaks in the wavelength range from 610 nm to less than 650 nm, and
a temperature change of light emitting intensity in the light emitting peak located in a short wavelength side among the multiple light emitting peaks is smaller than the temperature change of the light emitting intensity in the light emitting peak located in a long wavelength side.

5. The module according to any one of claims 1 to 4,
wherein the first phosphor (15) has an excitation band in the wavelength range from 300 nm to 550 nm, and has an absorption peak of excitation light in a wavelength range between 350 nm and 450 nm.

6. The module according to claim 5,
wherein intensity of the excitation band of the first phosphor (15), in the wavelength range of 500 nm or more, is equal to or less than 10% of the intensity of the absorption peak.

7. The module according to any one of claims 1 to 6,
wherein the second phosphor (17) has the light emitting peak in a wavelength range between the peak wavelength of the light emitting spectrum of the light emitting body (5) and the peak wavelength of the light emitting spectrum of the first phosphor (15).

8. The module according to any one of claims 1 to 7,
wherein an average particle diameter of the first phosphor (15) is equal to or more than 1.6 times an average particle diameter of the second phosphor (17).

9. The module according to any one of claims 1 to 8,
wherein content of the first phosphor (15) is equal to or more than three times content of the second phosphor (17).

10. The module according to claim 9,
wherein the content of the first phosphor (15) is from 3.8 times to 5 times the content of the second phosphor (17).

11. The module according to any one of claims 1 to 10,
wherein the first phosphor (15) includes a phosphor represented by a chemical formula of K₂SiF₆:Mn.

12. The module according to any one of claims 1 to 11, further comprising:
a first phosphor layer (11) disposed on the substrate (3) and including the first phosphor (15); and
a second phosphor layer (13) disposed between the substrate (3) and the first phosphor layer (11) and including the second phosphor (17).

13. The module according to claim 12,
wherein a refractive index of the first phosphor layer (11) is lower than a refractive index of the second phosphor layer (13).

14. The module according to any one of claims 1 to 13, further comprising:
a phosphor layer (11, 13) including at least one of the first phosphor (15) and the second phosphor (17); and
an intermediate layer (19) covering the light emitting body (5) on the substrate (3) and allowing the emitted light of the light emitting body (5) to be transmitted,
wherein the phosphor layer (11, 13) is disposed on the intermediate layer (19).

15. A lighting device comprising:
the light emitting module (10) according to claims 1 to 14; and
a housing (21) on which the light emitting module is mounted.
